# EUROPEAN PATENT SPECIFICATION

(11) **EP 2 204 829 B1**
(45) Date of publication and mention of the grant of the patent: **05.10.2011**
(21) Application number: 09150121.3
(22) Date of filing: 06.01.2009
(51) Int. Cl.: H01H 3/38, H01H 23/14, H03K 17/96, H03K 17/968

(54) **On/Off Switch**
An-/Aus-Schalter
Commutation marche/arrêt

(43) Date of publication of application: 07.07.2010
(73) Proprietor: Anywire Corporation, Nagaokakyo-shi, Kyoto 617-0813 (JP)
(72) Inventor: Yoshitane Saitou, Kyoto 617-0813 (JP); Kenji Nishikido, Kyoto 617-0813 (JP)
(74) Representative: Barnfather, Karl Jon

(56) References cited:
- EP-A- 0 810 544
- FR-A- 2 575 845
- JP-A- 2009 026 509
- US-A- 1 782 516
- US-A- 4 459 022
- US-A- 4 994 669
- "FLEXIBLE SHAFT INCREASES JOYSTICK DURABILITY" MACHINE DESIGN, PENTON MEDIA, CLEVELAND, OH, US, vol. 63, no. 25, 12 December 1991 (1991-12-12), page 70, XP000270164 ISSN: 0024-9114

## Description

### BACKGROUND OF THE INVENTION

### 1. Field of the Invention

The present invention relates to an ON/OFF switch which performs switching operation between two predetermined actions, such as lighting and extinction, or start and stop of an action apparatus.

### 2. Description of the Related Art

As a device for performing switching operation between two predetermined actions such as lighting and extinction, or start and stop of an action apparatus, ON/OFF switches are widely used. As such an ON/OFF switch, a device utilizing a contacting state of an electrically conductive member and a separated state thereof to conduct electrical connection to a circuit and electrical disconnection from the circuit (hereinafter, called "contact switch") is widely used and it is variously modified to various aspects suitable for use situations.

For example, JPA-2006-294574 proposes a simple contact switch with a simple structure which can cause a switch lever to have high operability. The simple contact switch uses a coil spring at a fulcrum portion of the switch lever, thereby allowing simplification of a structure of the lever switch with excellent operability, whose distal end can be inclined in an arbitrary direction in a whole circumferential direction (360°).

On the other hand, the contact switch includes such a problem as contact failure or wiring complexity in multi-functional configuration. Therefore, in order to solve such a problem, there is such a trial as adoption of a non-contact structure instead of a structure where an electrically conductive member in the contact switch causes mechanical contact. As such a non-contact type switch, there is a combination switch for a vehicle utilizing optical signal means, which is disclosed in JPA-11-306925. The combination switch for a vehicle is configured to perform action switching by blocking light arriving from a light emitting element to a light receiving element via a light guide plate using a slider sliding in response to movement of a lever switch to change a light amount arriving the light receiving element. That is, since the structure for sliding a slider for blocking a light path is adopted instead of the structure for causing mechanical contact, a problem attached to the contact switch can be solved.
Patent Literature 1: JPA-2006-29457
Patent Literature 2: JPA-11-306925

From patent publication FR-A-2575845 there is known an ON/OFF switch as set out in the pre-characterizing part of claim 1.

### SUMMARY OF THE INVENTION

However, since the combination switch for a vehicle is intended to perform switching in a plurality of sets of two actions utilizing one lever, the structure thereof is still complicated. Therefore, when simpler and lower cost structure including only one set of actions as a target to be switched is required, such a combination switch is improper. A movable range of individual lever switches is limited to one plane, where one lever cannot be tilted in an arbitrary direction in a whole circumferential direction.

In a first ON/OFF switch according to the present invention, one end of a cylindrical member having flexibility and being stretchable so as to be freely restored to a normal state is fixed to a base member, a rod member having flexibility is inserted into the cylindrical member and is supported by a guide maintaining a state of an axial line of the rod member to the cylindrical member regardless of the state of the cylindrical member, one end of the rod member is fixed to an end portion of the cylindrical member which is not fixed to the base member and the other end thereof is protruded from the cylindrical member, and a surrounding portion surrounding the end portion of the rod member which is protruded from the cylindrical member in a non-contact manner is provided. A converting unit converting movement of the end portion of the rod member protruded from the cylindrical member relative to the surrounding portion to electrical signal binary to output the same.

In the present invention, the electrical signal binary means so-called "1" or "0" signal, and it may also be a signal indicating whether or not a predetermined voltage is obtained at an output terminal, or the like. Incidentally, when the signal indicating whether or not a predetermined voltage is obtained is used, the predetermined voltage can be set to an optimal value according to use situation, for example, 5V±1V or 24V±2V can be adopted.

In the present invention, the term "state of an axial line of the rod member to the cylindrical member" may be thought as a relative positional relationship of the axial line of the rod member to an axial line of the cylindrical member. The term "maintaining a state of an axial line of the rod member to the cylindrical member" means, for example, that, when a rod member is inserted into a cylindrical member coaxially, the axial line of the rod member is caused to coincide with the axial line of the cylindrical member and that when the rod member is inserted into the cylindrical member such that an axial line of the former becomes parallel to an axial line of the latter, both the axial lines are kept parallel to each other.

Further, in the present invention, the term "a state that an end portion of the rod member has been surrounded by a surrounding portion" means a state that the surrounding member is disposed over a region including at least half of a length of the rod member in a outer peripheral direction thereof, where a length of the rod member in an axial direction thereof is not limited. For example, such a definition is made that even when a plate member with U shape in plan view having a thickness of about 1mm is applied to an end portion of a rod member with an entire length of about 10cm as the surrounding portion, a thickness direction of the plate member is made parallel to the axial direction of the rod member, and the rod member is disposed such that it is inserted into a recessed portion of the plate member, the end portion of the rodmember is surrounded by the surrounding portion.

The surrounding portion may have a peripheral wall continuing in an entire peripheral direction. In this case, the surrounding portion is arranged over a whole area of an outer circumferential direction of the rod member..In this case, of course, the end portion of the rod member is surrounded by the surrounding portion. Further, the surrounding portion may be longer than a movement region of an end portion of the rod member protruded from the cylindrical member in the axial line direction of the rod member. In this case, a portion of a distal end portion of the rod member reaching a certain length thereof is accommodated in the surrounding portion, so that the end portion of the rod member is surrounded in the surrounding portion. Incidentally, when the surroundingportion is configured so as to continue in the entire peripheral direction, the surrounding portion forms a cylindrical member.

The converting means may be provided with a light emitting element and a light receiving element, and it may be configured to perform conversion to the electrical signal binary utilizing according to presence and absence of light arriving from the light emitting element to the light receiving element. In this case, the light emitting element and the light receiving element may be arranged so as to maintain a positional relationship where a light path from the light emitting element to the light receiving element intersects a moving route of the end portion of the rod member protruded from the cylindrical member, or they may be arranged so as to maintain a positional relationship where light from the light emitting element is reflected by an end face of the end portion of the rod member protruded from the cylindrical member at the predetermined position to reach the light receiving element.

The end portion of the rod member protruded from the cylindrical member may include a permeability member attached to the rod member, and the converting means may be provided with a coil surrounding the permeability member in a normal state and an oscillation circuit connected to the coil to perform conversion to the electrical signal binary utilizing presence and absence of induced electromotive force.

The end portion of the rod member protruded from the cylindrical member may include a magnetic body attached to the rod member, and the converting means may be provided with a magnetic force sensor to perform conversion to the electrical signal binary utilizing strong and weak of magnetic force detected by the magnetic force sensor.

In the first ON/OFF switch according to the present invention, when force acting in a direction of bending a cylindrical member (hereinafter, called "bending force", which is similarly applied to the rod member) is applied to an end portion (hereinafter, called "free end", which is similarly applied to the rod member) of a cylindrical member to which one end of a rod member is fixed, a portion of the cylindrical member on which pulling force acts is stretched near an end portion (hereinafter, called "proximal end") of the cylindrical member fixed to the base member so that the cylindrical member is changed to a bend state and the rod member inserted into the cylindrical member is also bent similarly. At this time, a state of an axial line of the rod member to the cylindrical member is maintained by the guide regardless of the state of the cylindrical member, and attitude of the endportion of the cylindrical member to the base member is not changed so that attitudes of the axial line of the rod member to the base member before and after bending force acts on the cylindrical member become the same. That is, an end portion (hereinafter, called "moving end portion" of the rod member protruded from the cylindrical member moves in a direction of the free end along the axial line (hereinafter, called "original axial line") of the rod member before bending force acts on the rod member. The movement of the moving end portion of the rod member is not changed regardless of the direction of bending force acting on the free end. Therefore, movement of the moving end portion of the rod member is converted to movement along the original axial line of the moving end portion of the rod member regardless of a direction in which the free end is bent, which results in specific movement to the surrounding portion surrounding the moving end portion in a non-contacting manner. In view of these circumstances, by converting movement of the moving end portion relative to the surrounding portion to electrical signal binary to be outputted and causing two values of the binary to correspond to two predetermined actions, switching operation between these two actions can be performed.

In order to convert the movement of the moving end portion to electrical signal binary, light, magnetic force, induced electromotive force, and the like can be utilized. For example, by providing a light emitting element and a light receiving element as the converting means, conversion to electrical signal binary may be performed utilizing presence and absence of light arriving from the light emitting element to the light receiving element. At this time, in such a configuration that the light emitting element and the light receiving element are disposed in a positional relationship where a light path arriving from the light emitting element to the light receiving element intersects a moving route of the moving end portion of the rod member, when the light path is blocked by the rod member, light from the light emitting element does not reach the light receiving element, so that conversion to electrical signal binary can be performed utilizing presence and absence of light arriving from the light emitting element to the light receiving element. On the other hand, in such a configuration that the light emitting element and the light receiving element are disposed in a positional relationship where light from the light emitting element is reflected by an end face of the moving end portion at the predetermined position to reach the light receiving element, when the rod member moves and a relative position between the light emitting element and the light receiving element changes, light from the light emitting element does not reach the light receiving element, so that conversion to electrical signal binary can be performed utilizing presence and absence of light arriving from the light emitting element to the light receiving element.

When a permeability member is attached to the rod member, the converting means may be provided with a coil surrounding the permeability member in an ordinary state and an oscillation circuit connected to the coil. In this case, when the rod member moves so that the permeability member moves to a position where it is out of the coil, induced electromotive force becomes weak so that conversion to electrical signal binary can be performed utilizing strong and weak of the induced electromotive force.

Further, when a magnetic body is attached to the rod member, the converting means may be provided with a magnetic force sensor. In this case, when the rod member moves so that the relative distance between the magnetic body and the magnetic force sensor changes, magnetic force detected by the magnetic force sensor changes, so that conversion to electrical signal binary can be performed utilizing strong and weak of the magnetic force.

### BRIEF DESCRIPTION OF THE DRAWINGS

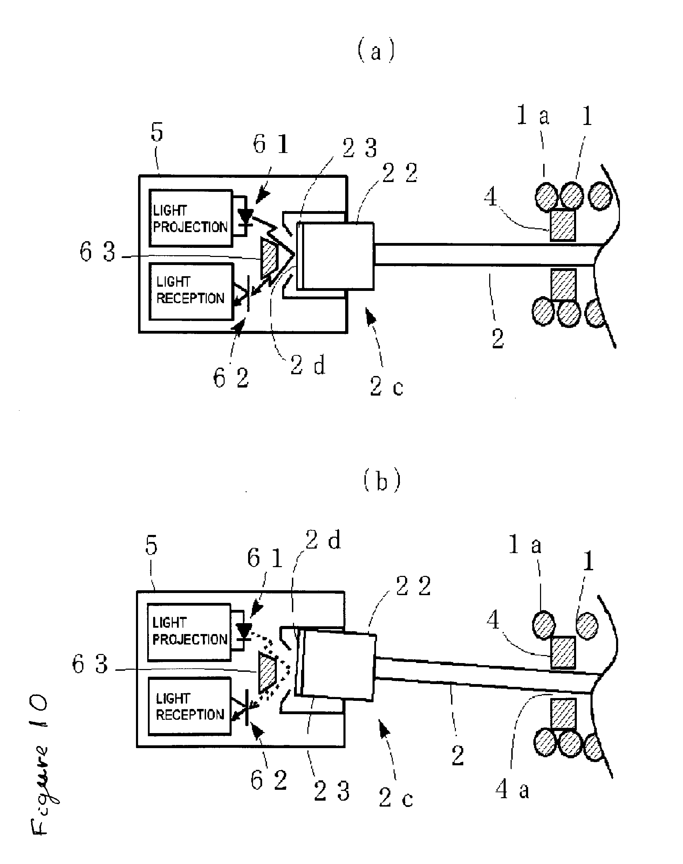

FIG. 1 is a perspective view showing an appearance of a main constituent portion of an ON/OFF switch according to an embodiment of the present invention;
FIGs. 2A and 2B are vertical sectional views for explaining an operation principle of the ON/OFF switch according to the embodiment, FIG. 2A showing an ordinary state and FIG. 2B showing a state that bending force has been applied to a free end;
FIGs. 3A and 3B are vertical sectional views for explaining an operation principle of converting means of the ON/OFF switch according to the embodiment, FIG. 3A showing an ordinary state and FIG. 3B showing a state that bending force has been applied to the free end;
FIGs. 4A and 4B are vertical sectional views for explaining an operation principle of converting means in another embodiment of the present invention, FIG. 4A showing an ordinary state and FIG. 4B showing a state that bending force has been applied to a free end;
FIGs. 5A and 5B are vertical sectional views for explaining an operation principle of converting means in still another embodiment of the present invention, FIG. 5A showing an ordinary state and FIG. 5B showing a state that bending force has been applied to a free end;
FIGs. 6A and 6B are vertical sectional views for explaining an operation principle of converting means utilizing induced electromotive force according to still another embodiment of the present invention, FIG. 6A showing an ordinary state and FIG. 6B showing a state that bending force has been applied to a free end;
FIGs. 7A and 7B are vertical sectional views for explaining an operation principle of converting means utilizing magnetic force according to still another embodiment of the present invention, FIG. 7A showing an ordinary state and FIG. 7B showing a state that bending force has been applied to a free end;
FIG. 8 is a perspective view of an appearance of a main constituent portion of an ON/OFF switch according to one example, which is not part of the present invention;
FIGs. 9A and 9B are vertical sectional views for explaining an operation principle of the ON/OFF switch according to the example, FIG. 9A showing an ordinary state and FIG. 9B showing a state that bending force has been applied to a free end; and
FIGs . 10A and 10B are vertical sectional views for explaining a principle of converting inclination of an end face of a moving end portion to electrical signal binary values in the ON/OFF switch according to the example, FIG. 10A showing an ordinary state and FIG. 10B showing a state that bending force has been applied to a free end.

### DETAILED DESCRIPTION OF THE PREFERRED EMBODIMENTS

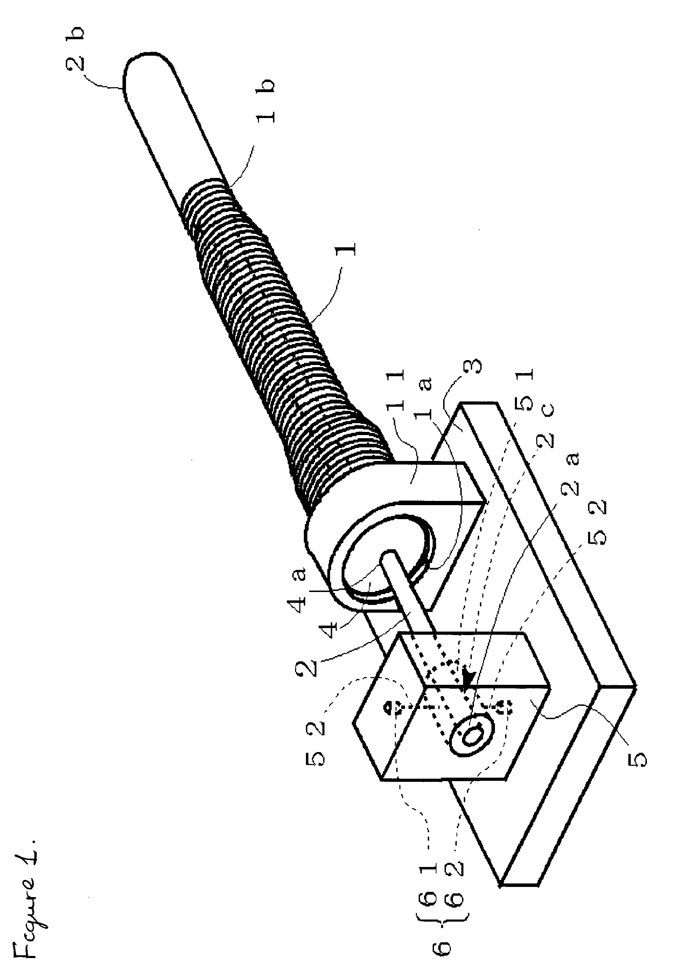

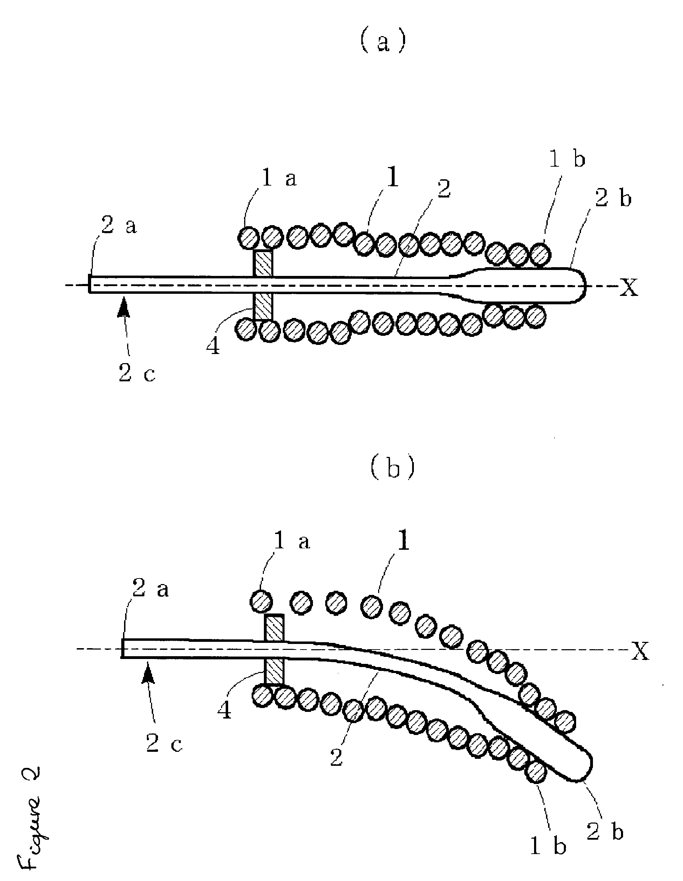

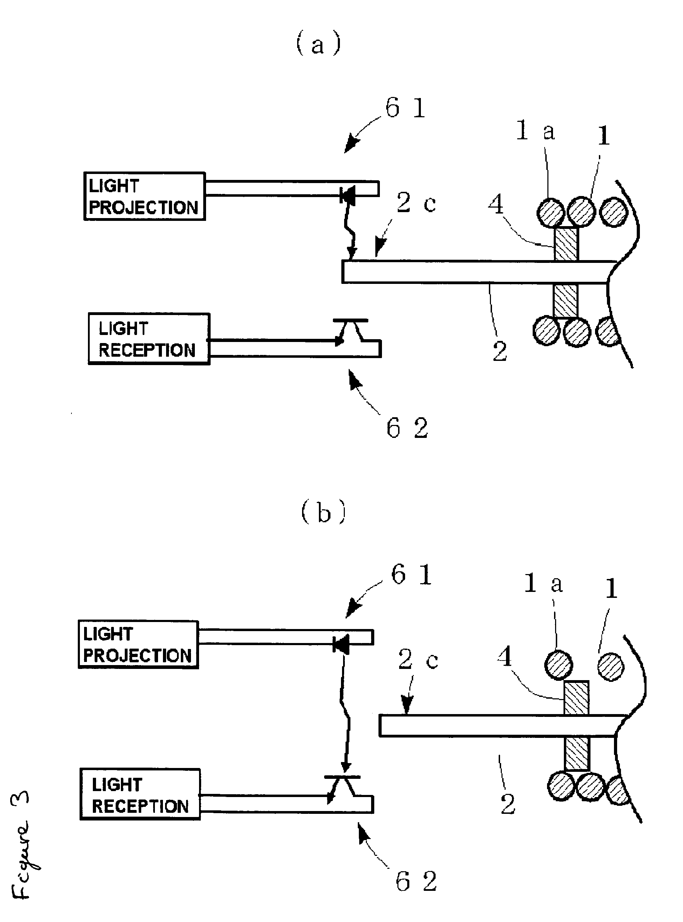

An embodiment of the present invention will be explained with reference to FIG. 1, FIGs. 2A and 2B, and FIGs. 3A and 3B. FIG. 1 is a perspective view showing an appearance of a main constituent portion of an ON/OFF switch according to the embodiment of the present invention. FIGs. 2A and 2B are vertical sectional views for explaining an operation principle of the ON/OFF switch according to the embodiment, FIG. 2A showing an ordinary state and FIG. 2B showing a state that bending force has been applied to a free end. FIGs. 3A and 3B are vertical sectional views for explaining an operation principle of converting means or unit of the ON/OFF switch according to the embodiment, FIG. 3A showing an ordinary state and FIG. 3B showing a state that bending force has been applied to the free end.

Main constituent elements of the ON/OFF switch comprises a cylindrical member 1, a rod member 2, a base member 3, a guide 4, a surrounding portion 5, and converting means 6.

A known coil spring is adopted as the cylindrical member 1, one end 1a (proximal end) of the cylindrical member is fixed to a base member 3 via a fixing member 11 fitted and fixed on an outer periphery of the one end 1a, and a rod member 2 is inserted into the cylindrical member 1. Incidentally, since the cylindrical member 1 is simply required to have flexibility and be stretchable so as to be restored to a normal state freely, material thereof or the like is not limited to specific one. Proper material can be selected for the cylindrical member 1 in response to a use situation or the like.

The rod member 2 is inserted into the cylindrical member 1 and it is supported by a guide 4. One end 2b of the rod member 2 is fixed to an end portion 1b (free end) of the cylindrical member 1 which is not fixed to the base member 3, and the other end 2a thereof is protruded from the cylindrical member 1. An end portion 2c (moving end portion) of the rod member 2 protruded from the cylindrical member 1 is surrounded by a surrounding portion 5 provided on the base member 3 in a non-contacting state. Incidentally, the rod member 2 is configured by molding synthetic resin and shaping the resin to a shape suitable for the ON/OFF switch, but since any material having flexibility and required strength can be used as the rod member 2, material to be used for the rod member 2 is not limited to a specific one. Proper material can be selected for the rod member 2 in response to a use situation or the like.

The guide 4 comprises a disk-like member, it is provided at its center with an insertion hole 4a for the rod member 2, and it is fitted in an opening of the proximal end 1a of the cylindrical member 1. The insertion hole 4a has an opening diameter slightly larger than an axis diameter of the rod member 2 such that sliding of the rod member 2 is allowed, but movement of the rod member 2 in a direction perpendicular to the axial line of the rod member 2 is restricted. Therefore, a state of the axial line of the rod member 2 relative to the cylindrical member 1 is maintained regardless of the state of the cylindrical member 1.

The surrounding portion 5 is provided with the converting means 6 which converts movement of the moving end portion 2c of the rod member 2 relative to the surrounding portion 5 to electrical signal binary to output the same.

The converting means 6 is provided with a light emitting element 61 and a light receiving element 62. The light emitting element 61 and the light receiving element 62 are disposed so as to face each other via a receiving hole 51 for the rod member 2 formed in the surrounding portion 5. The receiving hole 51 is opened to the light emitting element 61 and the light receiving element 62 via a light guiding passage 52. The light guiding passage 52 and the receiving hole 51 form a light path arriving from the light emitting element 61 to the light receiving element 62. That is, the light emitting element 61 and the light receiving element 62 are disposed in a positional relationship where the light path from the light emitting element 61 to the light receiving element 62 intersects a moving route of the moving end portion 2c of the rod member 2. Incidentally, In FIG. 1 and FIGs. 3A and 3B, illustration of other elements configuring the converting means 6 is omitted for sake of simplicity of explanation about a specific example.

As shown in FIGs . 2A and 2B, according to the ON/OFF switch, when bending force is applied to the free end 1b of the cylindrical member 1, a portion of the cylindrical member 1 on which pulling force acts is stretched in the vicinity of the proximal end 1a of the cylindrical member 1 so that the cylindrical member 1 is changed to a bent state, and the rod member 2 inserted into the cylindrical member 1 is similarly changed to a bent state (a state shown in FIG. 2B). At this time, a state of the axial line of the rod member 2 to the cylindrical member 1 is maintained regardless of the state of the cylindrical member 1, and an attitude of the proximal end 1a of the cylindrical member 1 to the base member 3 is not changed, so that attitudes of the axial line of the rod member 2 to the base member 3 before and after bending force is applied to the cylindrical member 1 are not changed. That is, the moving end portion 2c of the rod member 2 moves in a direction of the free end 2b along an original axial line X of the rod member 2 before the bending force is applied to the cylindrical member 1. The movement of the moving end portion 2c of the rod member 2 remains the same regardless of a direction of bending force applied to the free end 2b. Accordingly, regardless of a bending direction of the free end 2b, the movement of the bending is converted to movement along the original axial line X of the moving end portion 2c of the rod member 2, which results in specific movement to the surrounding portion 5 surrounding the moving end portion 2c in a non-contacting state.

On the other hand, as shown in FIGs. 3A and 3B, regarding the light emitting element 61 and the light receiving element 62, an ordinary state before application of bending force is put in a state that the light path is blocked by the rod member 2 (a state shown in FIG. 3A), and when bending force is applied to the free end 1b of the cylindrical member 1, the rod member 2 is flexed and the moving end portion 2c is moved toward the free end 2b so that the light path is put in an opened state (a state shown in FIG. 3B). When the light path is blocked by the rod member 2, light from the light emitting element 61 does not reach the light receiving element 62, so that conversion to electrical signal binary can be performed utilizing presence and absence of light arriving from the light emitting element 61 to the light receiving element 62. More specifically, a voltage difference occurs between electrodes of the light receiving element 62 when the light receiving element 62 receives light from the light emitting element 61, while the voltage difference becomes 0 when light from the light emitting element is blocked, so that conversion to electrical signals comprising two values of a signal "1" indicating presence of a voltage and a signal "0" indicating absence of a voltage can be performed. Accordingly, when these two values, namely, "1" and "0" are caused to correspond to two predetermined actions, switching operation between these actions can be performed. Incidentally, a voltage for determining presence of a voltage can be set to an optimal value according to use situation, for example, it may be set to 5V ± 1V or 24V ± 2V.

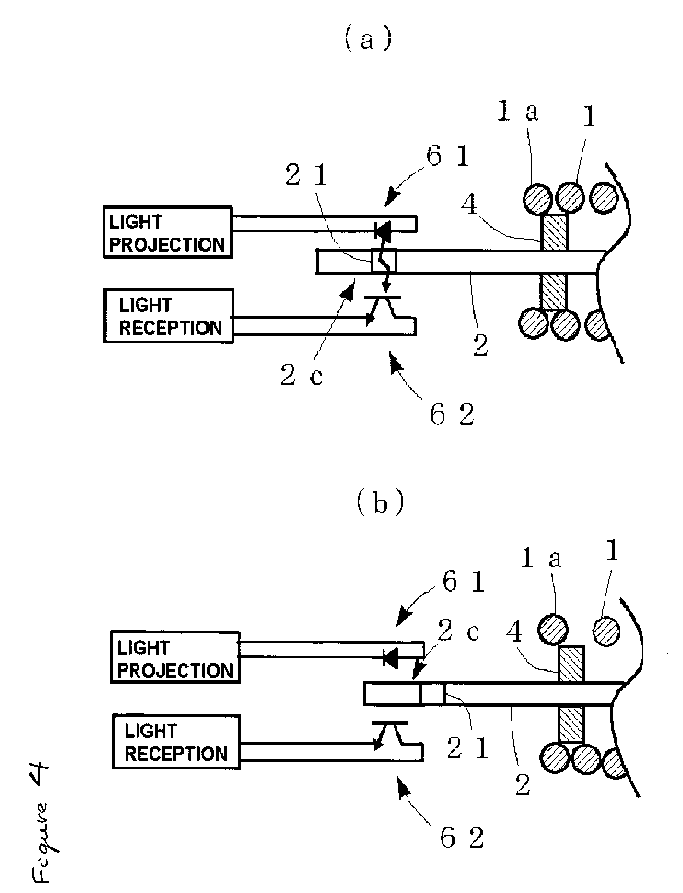

The light receiving element 62 in the ON/OFF switch indicates absence of received light in an ordinary state and it indicates presence of received light in a state that bending force has been applied to the free end 1b of the cylindrical member 1, but the relationship between the states of the rod member 2 and presence and absence of received light may be set to a reversed relationship to the abovementioned relationship. Another embodiment where the relationship between the states of the rod member 2 and presence and absence of received light is reversed to the relationship in the embodiment shown in FIG. 1, FIGs. 2A and 2B, and FIGs. 3A and 3B is shown in FIGs. 4A and 4B. FIGs . 4A and 4B are vertical sectional views for explaining an operation principle of converting means according to another embodiment of the present invention, FIG. 4A showing an ordinary state and FIG. 4B showing a state that bending force has been applied to a free end. Incidentally, portions substantially equal to those in the embodiment shown in FIG. 1, FIGs. 2A and 2B, and FIGs. 3A and 3B are attached with same reference numerals and explanation thereof is simplified or omitted.

In the embodiment, a light guiding passage 21 is formed in the rod member 2. The light path is put in an opened state (a state shown in FIG. 4A) in an ordinary state before bending force is applied to the free end 1b of the cylindrical member 1, and when bending force is applied to the free end 1b of the cylindrical member 1, the rod member 2 is flexed and the moving end portion 2c moves toward the free end 2b so that the light path is put in a blocked state by the rod member 2 (a state shown in FIG. 4B) . That is, the ordinary state indicates presence of received light and the state of application of bending force indicates absence of received light. Such a fact that, when the light path is blocked by the rod member 2, light from the light emitting element 61 does not reach the light receiving element 62 is similar to the embodiment shown in FIG. 1, FIGs. 2A and 2B, and FIGs. 3A and 3B. Accordingly, by performing conversion to electrical signal binary utilizing presence and absence of light arriving from the light emitting element 61 to the light receiving element 62 and causing two values of the binary to correspond to two predetermined actions respectively, switching operation between these two actions can be performed.

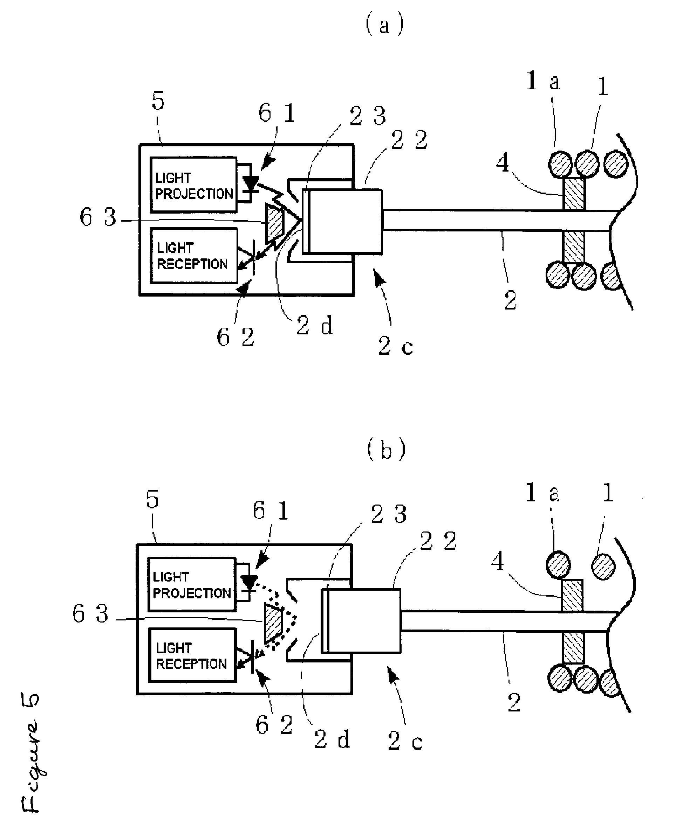

The light emitting element 61 and the light receiving element 62 may be arranged in a further different manner. Still another embodiment where arrangement of the light emitting element 61 and the light receiving element 62 has been changed is shown inFIGs. 5A and 5B. FIGs . 5A and 5B are vertical sectional views for explaining an operation principle of converting means in another embodiment of the present invention, FIG. 5A showing an ordinary state and FIG. 5B showing a state that bending force has been applied to a free end. Incidentally, inFIGs. 5A and 5B, portions substantially equal to those in the embodiment shown in FIG. 1, FIGs. 2A and 2B, and FIGs . 3A and 3B are attached with same reference numerals and explanation thereof is simplified or omitted.

In the embodiment, the surrounding portion 5 is configured so as to surround the moving end portion 2c of the rod member 2 including the end face 2d. An area of the end face 2d of the moving end portion is expanded by a diameter-expanding portion 22 formed on the moving end portion 2c. On the other hand, the light emitting element 61 and the light receiving element 62 face the end face 2d of the moving end portion and they are arranged in a positional relationship where light from the light emitting element 61 is reflected by the end face 2d of the moving end portion in an ordinary state to reach the light receiving element 62. Incidentally, a baffle plate 63 is provided between the light emitting element 61 and the light receiving element 62 such that light from the light emitting element 61 is prevented from directly entering the light receiving element 62 without hitting against the end face 2d of the moving end portion. A reflecting plate 23 for reflecting light form the light emitting element 61 excellently is provided on the diameter-expanding portion 22, so that a reflecting face of the reflecting plate 23 configures the end face 2d of the moving end portion.

According to this embodiment, the ordinary state before application of bending force is put in a state where light from the light emitting element 61 reaches the light receiving element 62 via the end face 2d of the moving end portion (a state shown in FIG. 5A), and when bending force acts on the cylindrical member 1, the rod member 2 is flexed and the moving end portion 2c moves toward the free end 2b, and distances between the light emitting element 61 and the light receiving element 62, and the end face 2d of the moving end portion become long so that a state that light from the light emitting element 61 does not reach the light receiving element 62 (a state shown in FIG. 5B) is formed. Accordingly, like the embodiments shown in FIG. 1, FIGS. 2A and 2B, FIGs. 3A and 3B, and FIGs. 4A and 4B, by performing conversion to electrical signal binary utilizing presence and absence of light arriving from the light emitting element 61 to the light receiving element 62 and causing two values of the binary to correspond to two predetermined actions respectively, switching operation between these two actions can be performed.

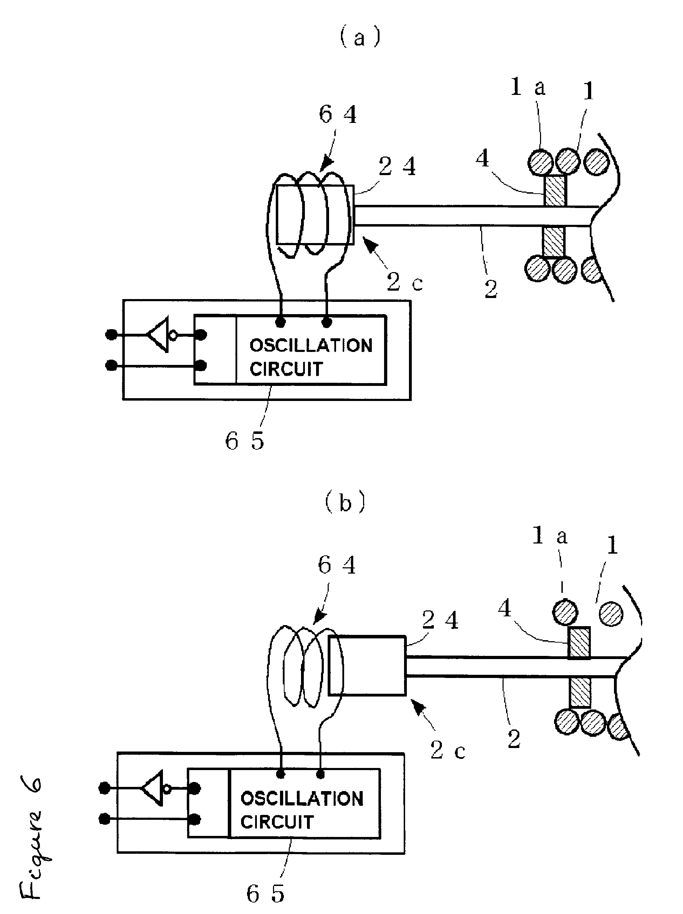

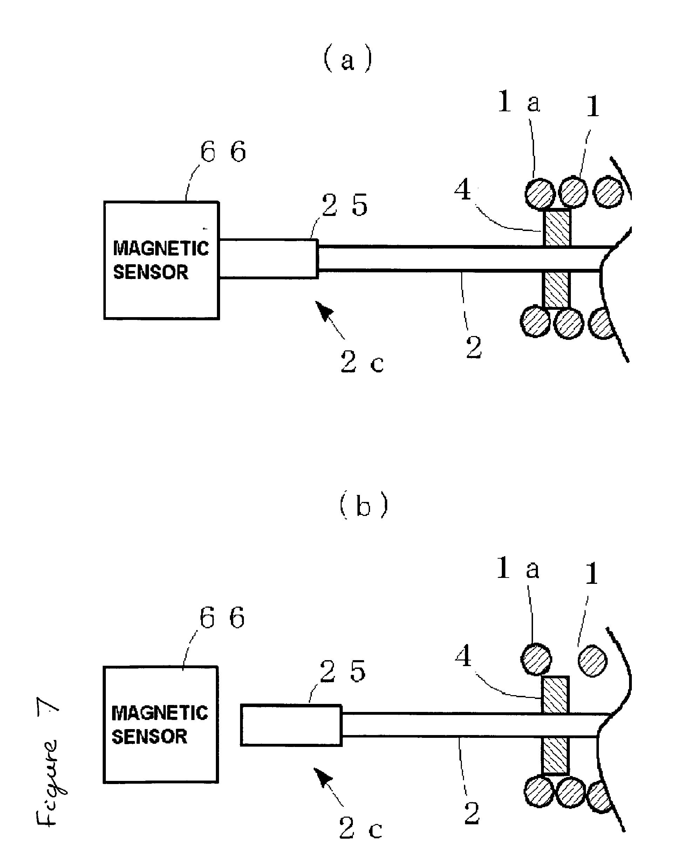

The converting means 6 which converts movement of the moving end portion to electrical signal binary may utilize a method other than the method utilizing light. Still other embodiments provided with converting means 6 which converts movement of the moving end portion 2c to electrical signal binary utilizing a method other than the method utilizing light are shown in FIGs. 6A and 6B, and FIGs. 7A and 7B, respectively. FIGs. 6A and 6B are vertical sectional views for explaining an operation principle of converting means utilizing induced electromotive force in another embodiment of the present invention, FIG. 6A showing an ordinary state and Figs 6B showing a state that bending force has been applied to a free end. FIGs. 7A and 7B are vertical sectional views for explaining an operation principle of converting means utilizing magnetic force in another embodiment of the present invention, FIG. 7A showing an ordinary state and FIG. 7B showing a state that bending force has been applied to a free end. Incidentally, in FIGs. 6A and 6B, and FIGs. 7A and 7B, portions substantially equal to those in the embodiment shown in FIG. 1, FIGs. 2A and 2B, and FIGs. 3A and 3B are attached with same reference numerals and explanation thereof is simplified or omitted.

In the embodiment shown in FIGs. 6A and 6B, a permeability member 24 is attached to the rod member 2 and it configures a portion of the moving end portion 2c. The converting means 6 is provided with a coil 64 surrounding the permeability member 24 in an ordinary state and an oscillation circuit 65 connected to the coil 64. Incidentally, an ordinary coil iron core member is used in the permeability member 24.

According to the embodiment, an ordinary state before application of bending force is put in a state that the permeability member 24 is disposed within the coil 64 (a state shown in FIG. 6A), and when AC current flows in the coil 64 by the oscillation circuit 65, strong induced electromotive force is generated. On the other hand, when bending force is applied to the free end of the cylindrical member 1, the rod member 2 is flexed, the moving end portion 2 moves toward the free end 2b, and a state that the permeability member 24 is out of the coil 64 (a state shown in FIG. 6B) takes place so that weak electromotive force is only generated even if AC current flows in the coil 64 by the oscillation circuit 65. Therefore, by performing conversion to electrical signal binary utilizing strong and weak of the induced electromotive force and causing two values of the binary to correspond to two predetermined actions respectively, switching operation between these two actions can be performed.

In the embodiment shown in FIGs. 7A and 7B, a magnetic body 25 is attached to the rod member 2 and it configures one portion of the moving end portion 2c. On the other hand, the converting means 6 is provided with a magnetic force sensor 66. Incidentally, an ordinary permanent magnet is used as the magnetic body 25. A known member using a Hall element is used as the magnetic force sensor 66.

According to this embodiment, an ordinary state before application of bending force is put in a state that the magnetic body has approached the magnetic force sensor (a state shown in FIG. 7A), where strong magnetic force is detected by the magnetic force sensor. On the other hand, when bending force is applied to the free end of the cylindrical member 1, the rod member 2 is flexed, the moving end portion moves toward the fixed end, and a state that the magnetic body has been separated from the magnetic force sensor (a state shown in FIG. 7B) takes place, so that weak magnetic force is detected by the magnetic force sensor. Therefore, by performing conversion to electrical signal binary utilizing strong and weak of the magnetic force detected by the magnetic force sensor and causing two values of the binary to correspond to two predetermined actions respectively, switching operation between these two actions can be performed.

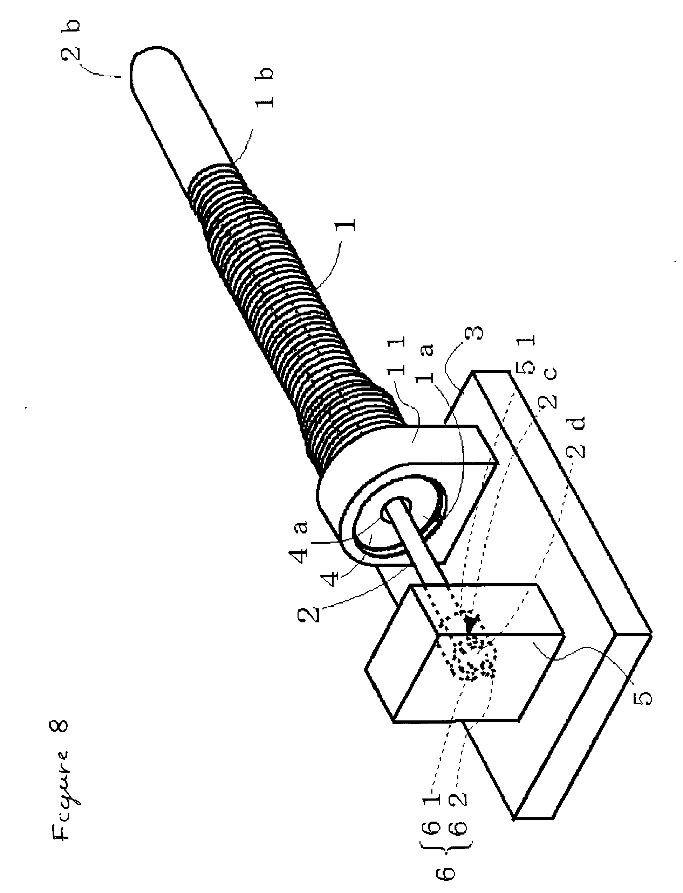

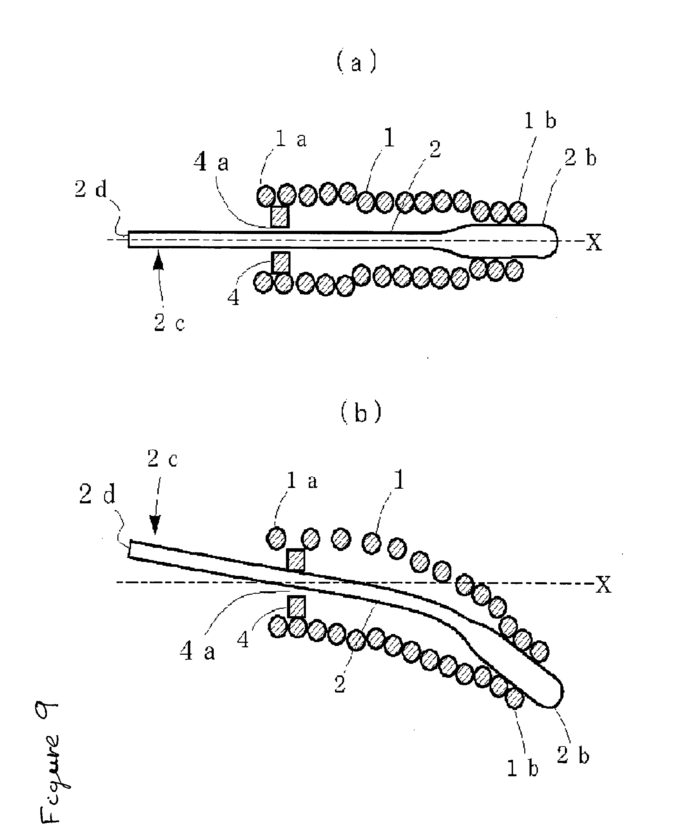

Still one example, which is not part of the present invention will be explained with reference to FIG. 8, FIGs. 9A and 9B, and FIGs. 10A and 10B. FIG. 8 is a perspective view showing an appearance of a main constituent portion of an ON/OFF switch according to the embodiment. FIGs . 9A and 9B are vertical sectional views for explaining an operation principle of the ON/OFF switch according to the example, FIG. 9A showing an ordinary state and FIG. 9B showing a state that bending force has been applied to a free end. FIGs . 10A and 10B are vertical sectional views for explaining a principle of converting inclination of an end face of the moving end portion to electrical signal binary in the ON/OFF switch according to the example, FIG. 10A showing an ordinary state and FIG. 10B showing a state that bending force has been applied to a free end. Incidentally, in FIG. 8, FIGs. 9A and 9B, and FIGs. 10A and 10B, portions substantially equal to those in the embodiments shown in FIG. 1, FIGs. 2A and 2B, FIGs. 3A and 3B, FIGs. 4A and 4B, FIGs . 5A and 5B, FIGs . 6A and 6B, and FIGs. 7A and 7B are attached with same reference numerals and explanation thereof is simplified or omitted.

This embodiment has a configuration that the diameter of the insertion hole of the guide 4 in the embodiment shown in FIG. 1, FIGs . 2A and 2B, and FIGs . 3A and 3B has been enlarged, where limitation to movement of the rod member 2 in a direction perpendicular to the axial line thereof is relaxed. Therefore, as shown in FIGS. 9A and 9B, when bending force is applied to the free end 1b of the cylindrical member 1 so that the cylindrical member 1 is put in a bent state, the moving end portion 2c of the rod member 2 is separated from the original axial line X of the rod member 2 so that the axial line of the bent rod member 2 is put in an inclined state forming an angle to the original axial line X (a state shown in FIG. 9B). At this time, the end face 2d of the moving end portion 2c is also inclined to a state thereof before application of the bending force. Accordingly, regardless of a bending direction of the free end 2b, movement thereof is converted to movement of inclining the end face 2d of the moving end portion 2c of the rod member 2 . Therefore, by converting inclination of the end face 2d of the moving end portion of the rod member 2 to electrical signal binary to output the same and causing two values of the binary to correspond to two predetermined actions respectively, switching operation between these two actions can be performed.

The surrounding portion 5 is configured so as to surround the moving end portion 2c of the rod member 2 including the end face 2d, and one having the same configuration as that of the embodiment shown in FIGs. 5A and 5B is adopted as the converting means 6. Incidentally, an area of the end face 2d of the moving end portion is expanded by the diameter-expanding portion 22 formed on the moving end portion 2c like the embodiment shown in FIGs. 5A and 5B, and a reflecting plate 23 for reflecting light from the light emitting element 61 excellently is attached to the diameter-expanding portion 22, so that a reflecting face of the reflecting plate 23 configures the end face 2d of the moving end portion.

According to this example, an ordinary state before application of bending force is put in a state that light from the light emitting element 61 reaches the light receiving element 62 via the end face 2d of the moving end portion (a state shown in FIG. 10A), and when bending force is applied on the free end 1b of the cylindrical member 1, the rod member 2 is flexed and the end face 2d of the moving end portion is inclined so that a state that an incident angle of light from the light emitting element 61 changes and light from the light emitting element 61 does not reach the light receiving element 62 (a state shown in FIG. 10B) takes place. Accordingly, by performing conversion to electrical signal binary utilizing presence and absence of light arriving from the light emitting element 61 to the light receiving element 62 and causing two values of the binary to correspond to two predetermined actions respectively, switching operation between these two actions can be performed.

## Claims

1. An ON/OFF switch wherein one end (1a) of a cylindrical member (1) having flexibility and being stretchable so as to be freely restored to a normal state is fixed to a base member (3), a rod member (2) having flexibility is inserted into the cylindrical member, one end (2b) of the rod member is fixed to an end portion (1b) of the cylindrical member which is not fixed to the base member while the other end (2a) thereof is protruded from the cylindrical member, a surrounding portion (5) surrounding the end portion of the rod member which is protruded from the cylindrical member in a non-contact manner is provided, and a converting unit (6) converting movement of the end portion of the rod member protruded from the cylindrical member relative to the surrounding portion to electrical signal binary to output two values of the binary is provided in the surrounding portion,
**characterized in that**
the rod member is supported by a guide (4) maintaining a state of an axial line of the rod member to the cylindrical member regardless of the state of the cylindrical member.

2. The ON/OFF switch according to claim 1, wherein the converting unit is provided with a light emitting element and a light receiving element to perform conversion to the electrical signal binary utilizing presence and absence of light arriving from the light emitting element to the light receiving element.

3. The ON/OFF switch according to claim 2, wherein the light emitting element and the light receiving element are arranged in a positional relationship where a light path arriving from the light emitting element to the light receiving element intersects a moving route of the end portion of the rod member protruded from the cylindrical member.

4. The ON/OFF switch according to claim 2, wherein the light emitting element and the light receiving element are arranged in a positional relationship where light from the light emitting element is reflected by an end face of the end portion of the rod member protruded from the cylindrical member at a predetermined position to reach the light receiving element.

5. The ON/OFF switch according to any preceding claim, wherein the end portion of the rod member protruded from the cylindrical member includes a permeability member attached to the rod member, and the converting unit is provided with a coil surrounding the permeability member in an ordinary state and an oscillation circuit connected to the coil to perform conversion to the electrical signal binary utilizing strong and weak of induced electromotive force.

6. The ON/OFF switch according to any preceding claim, wherein the end portion of the rod member protruded from the cylindrical member includes a magnetic body attached to the rod member, and the converting unit is provided with a magnetic force sensor to perform conversion to the electrical signal binary utilizing strong and weak of magnetic force detected by the magnetic force sensor.

## Patentansprüche

1. EIN/AUS-Schalter, bei welchem ein Ende (1a) eines zylindrischen Teils (1), das flexibel und streckbar ist, so dass es frei in einen normalen Zustand rückstellbar ist, an einem Basisteil (3) befestigt ist, wobei ein flexibles Stangenteil (2) in das zylindrische Teil eingesetzt ist, wobei ein Ende (2b) des Stangenteils an einem Endbereich (1b) des zylindrischen Teils befestigt ist, welcher nicht an dem Basisteil befestigt ist, während das andere Ende (2a) desselben aus dem zylindrischen Teil herausragt, wobei ein Umfassungsteil (5) vorgesehen ist, welches den aus dem zylindrischen Teil ragenden Endbereich des Stangenteils berührungslos umgibt, und wobei in dem Umfassungsteil eine Umwandlungseinheit (6) vorgesehen ist, welcher die Belegung des aus dem zylindrischen Teil ragenden Endbereichs des Stangenteils in Bezug auf das Umfassungsteil in binäre elektrische Signale umwandelt, um zwei binäre Werte auszugeben,
**dadurch gekennzeichnet, dass**
das Stangenteil von einer Führung (4) gestützt ist, welche das Stangenteil ungeachtet des Zustands des zylindrischen Teils in einer axialen Linie in Bezug auf das zylindrische Teil hält.

2. EIN/AUS-Schalter nach Anspruch 1, bei welchem die Umwandlungseinheit mit einem Licht emittierenden Element und einem Licht empfangenden Element versehen ist, um die Umwandlung in das binäre elektrische Signal unter Verwendung des Vorhandenseins und des Nichtvorhandenseins von Licht durchzuführen, das von dem Licht emittierenden Element aus bei dem Licht empfangenden Element ankommt.

3. EIN/AUS-Schalter nach Anspruch 2, bei welchem das Licht emittierende Element und das Licht empfangende Element in einer Positionsbeziehung angeordnet sind, bei welcher ein von dem Licht emittierenden Element aus zu dem Licht empfangenden Element verlaufender Lichtweg eine Bewegungsbahn des aus dem zylindrischen Teil ragenden Endbereichs des Stangenteils schneidet.

4. EIN/AUS-Schalter nach Anspruch 2, bei welchem das Licht emittierende Element und das Licht empfangende Element in einer Positionsbeziehung angeordnet sind, bei welcher von dem Licht emittierenden Element kommendes Licht von einer Endfläche des aus dem zylindrischen Teil ragenden Endbereichs des Stangenteils an einer vorbestimmten Position reflektiert wird, so dass es das Licht empfangende Element erreicht.

5. EIN/AUS-Schalter nach einem der vorhergehenden Ansprüche, bei welchem der aus dem zylindrischen Teil ragende Endbereich des Stangenteils ein an dem Stangenteil angebrachtes Permeabilitätsteil aufweiset, und die Umwandlungseinheit mit einer das Permeabilitätsteil im Normalzustand umgebenden Spule und einer Oszillationsschaltung versehen ist, welche mit der Spule verbunden ist, um unter Verwendung starker und schwacher induzierter elektromotorischer Kraft die Umwandlung in das binäre elektrische Signal durchzuführen.

6. EIN/AUS-Schalter nach einem der vorhergehenden Ansprüche, bei welchem der aus dem zylindrischen Teil ragende Endbereich des Stangenteiis einen an dem Stangenteil angebrachten Magnetkörper aufweist, und die Umwandlungseinheit mit einem Magnetkraftsensor versehen ist, um die Umwandlung in das binäre elektrische Signal unter Verwendung von durch den Magnetkraftsensor erkannter starker und schwacher Magnetkraft durchzuführen.

## Revendications

1. Interrupteur Marche/Arrêt, dans lequel une extrémité (1a) d'un élément cylindrique (1) étant flexible et étirable de manière à pouvoir revenir librement à un état normal est fixée à un élément de base (3), un élément de tige (2) flexible est inséré dans l'élément cylindrique, une extrémité (2b) de l'élément de tige est fixée à une portion d'extrémité (1b) de l'élément cylindrique qui n'est pas fixée à l'élément de base tandis que l'autre extrémité (2a) de celui-ci fait saillie de l'élément cylindrique, une portion adjacente (5) entourant la portion d'extrémité de l'élément de tige qui fait saillie sans contact de l'élément cylindrique est prévue, et dans la portion adjacente est prévue une unité de conversion (6) convertissant le mouvement de la portion d'extrémité de l'élément de tige faisant saillie de l'élément cylindrique par rapport à la portion adjacente en signaux électriques binaires pour fournir en sortie deux valeurs du binaire,
**caractérisé en ce que**
l'élément de tige est supporté par un guide (4) maintenant un état d'une ligne axiale de l'élément de tige par rapport à l'élément cylindrique, quel que soit l'état de l'élément cylindrique.

2. Interrupteur Marche/Arrêt selon la revendication 1, dans lequel l'unité de conversion est munie d'un élément émetteur de lumière et d'un élément récepteur de lumière pour réaliser la conversion en signaux électriques binaires en se basant sur la présence et l'absence de lumière arrivant de l'élément émetteur de lumière à l'élément récepteur de lumière.

3. Interrupteur Marche/Arrêt selon la revendication 2, dans lequel l'élément émetteur de lumière et l'élément récepteur de lumière sont agencés dans une relation de position où un trajet lumineux arrivant de l'élément émetteur de lumière à l'élément récepteur de lumière croise un parcours en mouvement de la portion d'extrémité de l'élément de tige faisant saillie de l'élément cylindrique.

4. Interrupteur Marche/Arrêt selon la revendication 2, dans lequel l'élément émetteur de lumière et l'élément récepteur de lumière sont agencés dans une relation de position où la lumière provenant de l'élément émetteur de lumière est reflétée par une face d'extrémité de la portion d'extrémité de l'élément de tige faisant saillie de l'élément cylindrique à une position prédéterminée pour atteindre l'élément récepteur de lumière.

5. Interrupteur Marche/Arrêt selon l'une quelconque des revendications précédentes, dans lequel la portion d'extrémité de l'élément de tige faisant saillie de l'élément cylindrique comprend un élément de perméabilité fixé à l'élément de tige, et l'unité de conversion est munie d'une bobine entourant l'élément de perméabilité dans un état ordinaire et d'un circuit d'oscillation connecté à la bobine pour réaliser la conversion en signaux électriques binaires en se basant sur le niveau élevé et faible de la force électromotrice induite.

6. Interrupteur Marche/Arrêt selon l'une quelconque des revendications précédentes, dans lequel la portion d'extrémité de l'élément de tige faisant saillie de l'élément cylindrique comprend un corps magnétique fixé à l'élément de tige, et l'unité de conversion est munie d'un capteur de force magnétique pour réaliser la conversion en signaux électriques binaires en se basant sur le niveau élevé et faible de la force magnétique détectée par le capteur de force magnétique.
